# EUROPÄISCHE PATENTSCHRIFT

(11) **EP 2 111 647 B1**
(45) Veröffentlichungstag und Bekanntmachung des Hinweises auf die Patenterteilung: **12.06.2019**
(21) Anmeldenummer: 08716408.3
(22) Anmeldetag: 10.03.2008
(51) Int. Cl.: H01L 31/09, H01L 31/18, H01L 31/0304, H01S 1/02

(54) **SCHNELLER PHOTOLEITER**
RAPID PHOTOCONDUCTOR
PHOTOCONDUCTEUR RAPIDE

(30) Priorität: 15.03.2007 DE 102007012475
(43) Veröffentlichungstag der Anmeldung: 28.10.2009
(73) Patentinhaber: Fraunhofer-Gesellschaft zur Förderung der angewandten Forschung e.V., 80686 München (DE)
(72) Erfinder: SARTORIUS, Bernd, 14052 Berlin (DE); KÜNZEL, Harald, 12247 Berlin (DE); ROEHLE, Helmut, 13629 Berlin (DE); BIERMANN, Klaus, 10437 Berlin (DE)
(74) Vertreter: Schenk, Markus
(86) Internationale Anmeldenummer: PCT/EP2008/001899
(87) Internationale Veröffentlichungsnummer: WO 2008/110329

(56) Entgegenhaltungen:
- WO-A-98/28656
- WO-A-2006/011668
- WO-A-2006/063233
- DE-B3-102006 010 297
- US-A1- 2003 127 673
- CHEN YUE ET AL: "Trapping and recombination dynamics of low-temperature-grown InGaAs/InAlAs multiple quantum wells" APPLIED PHYSICS LETTERS, AIP, AMERICAN INSTITUTE OF PHYSICS, MELVILLE, NY, Bd. 72, Nr. 4, 26. Januar 1998 (1998-01-26), Seiten 439-441, XP012020600 ISSN: 0003-6951
- SCHOMBURG E. ET AL.: "InGaAs/InAlAs superlattice detector for THz radiation" PHYSICA E, Bd. 13, Nr. 2-4, März 2002 (2002-03), Seiten 912-915, XP002511537 Elsevier, Netherlands
- SARTORIUS B ET AL: "Telecom components for terahertz applications: LT InGaAs photoconductors for coherent detection close the gap" 33RD EUROPEAN CONFERENCE AND EXHIBITION ON OPTICAL COMMUNICATION - ECOC 2007, VDE VERLAG, DE, Bd. 3, 19. September 2007 (2007-09-19), Seiten P045/117-118, XP008099970 ISBN: 978-3-8007-3042-1
- WILK R ET AL: "THz Time-Domain Spectrometer Based on LT-InGaAs Photoconductive Antennas Exited by a 1.55 Î 1/4 m Fibre Laser" CLEO '07. 2007 CONFERENCE ON LASERS AND ELECTRO-OPTICS 5-11 MAY 2007 BALTIMORE, MD, USA, PISCATAWAY, NJ, USA, 6. Mai 2007 (2007-05-06), Seiten 1-2, XP031231190 ISBN: 978-1-55752-834-6

## Beschreibung

Die vorliegende Erfindung bezieht sich auf einen Photoleiter und ein Verfahren zur Herstellung desselben, wobei der Photoleiter beispielsweise zur Erzeugung von elektromagnetischer Terahertzstrahlung (THz = Terahertz) eingesetzt werden kann.

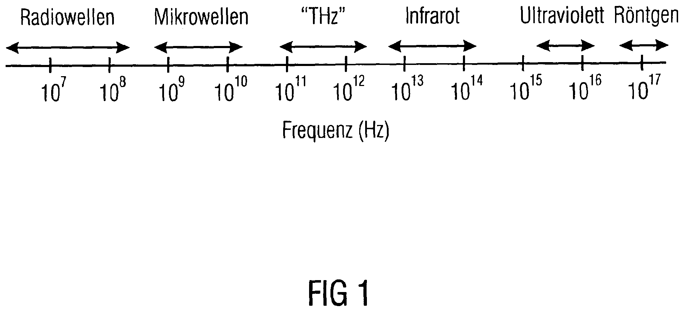

Bildgebende Verfahren spielen in der modernen Medizin eine maßgebende Rolle. Dabei findet beispielsweise die Röntgenstrahlung neben Ultraschall und kernmagnetischer Resonanz erhöhten Einsatz. Die ionisierende Wirkung der hochenergetischen Röntgenstrahlung stellt jedoch ein Gesundheitsrisiko dar. Da die Wärmestrahlung des menschlichen Körpers schwache Anteile von THz-Strahlung enthält, kann eine Alternative zur Röntgenstrahlung beispielsweise im Terahertz-Bereich zwischen Infrarotstrahlung und Mikrowellenstrahlung gesehen werden. Wie es in Fig. 1 gezeigt ist, liegt der THz-Bereich ca. zwischen 0,1 und 10 THz. Als weitere Einsatzbereiche für die THz-Strahlung können beispielsweise Überwachungs- bzw. Durchleuchtungssysteme für den Luftverkehr, oder weitere Konzepte in der Sicherheitstechnik, wie beispielsweise eine Kontrolle von Treibstofftanks auf verborgene Risse gesehen werden.

THz-Systeme können beispielsweise mit sogenannten Femtosekunden-Lasern realisiert werden. Diese Laser senden nur wenige Femtosekunden (fs) dauernde Lichtblitze aus. Werden diese kurzen Lichtblitze auf eine sogenannte photoleitende Antenne aus einem photoleitenden Halbleitermaterial und darauf aufgebrachten dünnen Leiterbahnen gerichtet, kann durch eine durch die Lichtpulse angeregte Beschleunigung von Elektronen THz-Strahlung erzeugt werden.

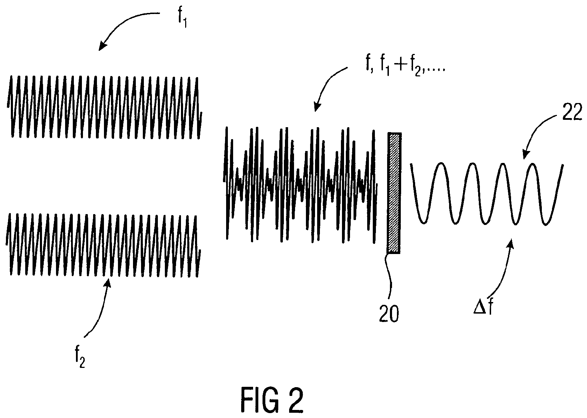

Femtosekundenlaser sind allerdings relativ teuer. Ein weiteres Konzept zur Erzeugung von Terahertz-Strahlung kann mittels preiswerter Laser bzw. Laserdioden durch eine sog. Photomischung erreicht werden. Um durch Photomischung THz-Strahlung zu erzeugen, kann das in Fig. 2 dargestellte Prinzip verwendet werden. Dabei werden zwei nahezu identische Laserdioden verwendet, die sich in ihren ausgesendeten Lichtfrequenzen f₁ bzw. f₂ nur geringfügig unterscheiden. Der Frequenzunterschied Δf zwischen f₁ und f₂ wird so eingestellt, dass die Differenzfrequenz Δf im THz-Bereich liegt. Durch Überlagerung der beiden Lichtfelder erhält man eine Frequenzschwebung mit der Differenzfrequenz Δf. Das Schwebungssignal wird nun auf eine sogenannte photoleitende Antenne 20 geleitet. Die photoleitende Antenne 20 weist ein photoleitendes Halbleitermaterial, wie beispielsweise GaAs (Galliumarsenid) oder InGaAs (Indiumgalliumarsenid), auf. Durch das überlagerte Licht und den Photoeffekt werden bewegliche Elektronen zunächst erzeugt und dann durch eine über Elektroden angelegte Spannung beschleunigt, wodurch elektromagnetische Strahlung im THz-Bereich emittiert wird. Die Anzahl der erzeugten Ladungsträger bzw. Elektron-Loch-Paare ist dabei abhängig von der Intensität des Schwebungssignals, d.h. die Anzahl der freien Ladungsträger ändert sich periodisch mit der Frequenz des Schwebungsignals. Der Strom in der Antenne ändert sich also mit der Schwebungsfrequenz, und somit wird ein elektromagnetisches Feld 22 mit der Differenzfrequenz Δf, die durch geeignete Wahl der Frequenzen der Laserdioden im THz-Bereich liegt, abgestrahlt.

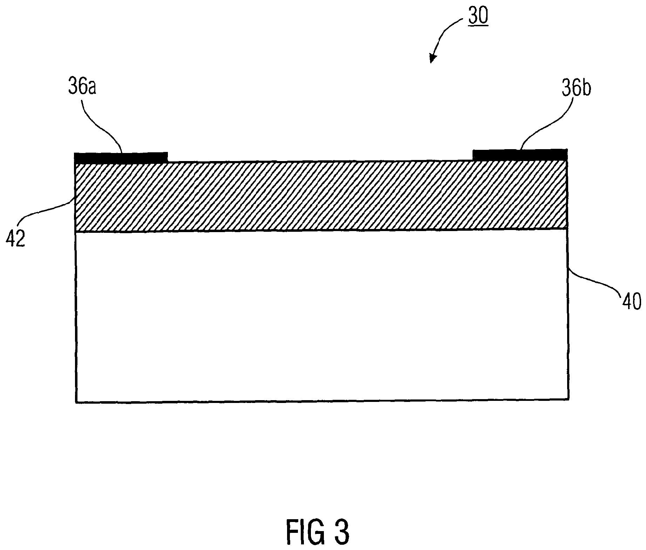

Fig. 3 zeigt einen schematischen Querschnitt eines möglichen Photoleiters 30. Der Photoleiter 30 umfasst ein isolierendes bzw. semi-isolierendes Halbleitersubstrat 40 und eine auf das Halbleitersubstrat 40 aufgebrachte photoleitende Dünnschicht 42. Auf die massive photoleitende Halbleiterschicht 42 sind Elektroden 36a,b aufgebracht.

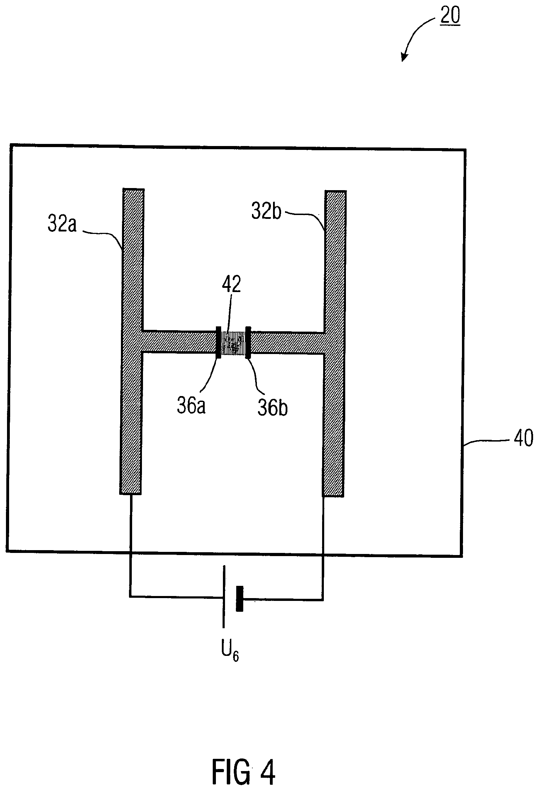

Eine prinzipielle Darstellung einer photoleitenden Antenne 20 bzw. einer THz-Antenne mit einem Photoleiter ist in Draufsicht in Fig. 4 gezeigt.

Die THz-Antenne 20 umfasst ein isolierendes Substrat 40, auf das zwei Leiterbahnen 32a und 32b aufgebracht sind. Dabei kann es sich beispielsweise um lithographisch aufgebrachte Leiterbahnen aus Gold handeln. Bei der in Fig. 4 exemplarisch gezeigten so genannten H-Struktur weisen die Leiterbahnen 32a und 32b zusätzlich einen zentralen Steg auf, der in seiner Mitte noch eine Lücke von wenigen µm aufweist. In der Lücke des zentralen Stegs ist auf dem Substrat 40 eine massive photoleitende Halbleiterschicht 42 aufgebracht, die über Elektroden 36a,b elektrisch leitend mit den zwei Leiterbahnen 32a und 32b verbunden ist. Über die Elektroden 36a,b bzw. die Leiterbahnen 32a,b kann für einen Sendebetrieb eine Spannung U_{b} angelegt werden.

Auf die photoleitende Halbleiterschicht 42 in der Lücke des Stegs wird, wie im Vorhergehenden bereits beschrieben wurde, Licht mit zwei leicht gegeneinander verstimmten Frequenzen f₁ und f₂ fokussiert, so dass ein Schwebungssignal im THz-Bereich entsteht. In der photoleitenden Halbleiterschicht 42 werden durch die Strahlung freie Ladungsträger erzeugt, welche durch Kristallgitterstörstellen sehr schnell wieder eingefangen werden. Dabei ist die Ladungsträgerdichte proportional zur Lichtintensität. Zwischen den Elektroden 36a,b wird für einen Sendebetrieb ein elektrisches Feld angelegt, welches die Ladungsträger zu den Elektroden 36a,b hin beschleunigt. Dadurch entsteht ein Ladungsträgerstrom zwischen den Elektroden 36a,b. Da die Lichtintensität durch das Schwebungssignal im THz-Bereich moduliert wird, entsteht auch ein Wechselstrom mit THz-Frequenzen. Durch diesen Wechselstrom wird ein elektromagnetisches Feld 22 im THz-Bereich erzeugt, d.h. es wird über die Leiterbahnen 32a,b THz-Strahlung emittiert. Um die Effizienz der THz-Strahlung zu verbessern, kann auf ihre Austrittsfläche, d.h. die Steglücke, eine hochresistive Siliziumlinse angebracht werden, welche die emittierte THz-Strahlung bündelt.

Die in Fig. 4 dargestellte photoleitende Antenne 20 kann sowohl zum Senden als auch zum Empfangen von THz-Strahlung eingesetzt werden.

Zur Erzeugung und Detektion von THz-Strahlung durch photoleitende Antennen oder Photomischer 20 werden schnelle Photoleiter mit folgenden Eigenschaften benötigt:
- elektrisch isolierend in Abwesenheit von Beleuchtung, d.h. hoher Dunkelwiderstand,
- Photoempfindlichkeit bei bestimmten Wellenlängen,
- Hohe Beweglichkeit von erzeugten Photoladungsträgern,
- Schnelles Abklingen in den isolierenden Zustand nach Abschalten der Beleuchtung.

Ein schnelles Abklingen der Photoleitfähigkeit wird durch Einbau von Punktdefekten, die schnelle Rekombinationszentren darstellen, in die photoleitende Halbleiterschicht 42 erreicht. Prominentes Beispiel sind sog. LT (Low Temperature) GaAs Schichten, die mit Molekularstrahlepitaxie (MBE) bei tiefen Temperaturen (< 200°C) auf GaAs abgeschieden werden. Molekularstrahlepitaxie ist ein vakuumbasiertes Beschichtungsverfahren, um kristalline Schichten herzustellen. Es resultieren als Folge des LT-Wachstums tiefe Störstellen in Form von Punktdefekten bzw. Störstellen-Cluster, die zur Rekombination im sub-ps Bereich führen. LT-GaAs wird deshalb als das Standard-Material für Photoleiterbasierte THz-Antennen genutzt (siehe z.B. B.S. Gupta, J.F. Whitaker, G.A. Mourou, "Ultrafast carrier dynamics in III-V semiconductors grown by molecular-beam epitaxy at very low substrate temperatures", IEEE J. Quantum Electron. 28, 2464, (1992) oder D. Mittleman (Editor) "Sensing with Terahertz Radiation", ISBN 3-540-43110-1 Springer Verlag Berlin-Heidelberg New York, 2003, Kapitel "Photomixer for Continuous-Wave Terahertz Radiation von S. M. Duffy, S. Verghese, K.A. McIntosh, pp. 190, sowie I.S. Gregory, C. Baker, W.R. Tribe, I.V. Bradley, M.J. Evans, E.H. Linfield, A.G. Davies, M. Missous, "Optimization of photomixers and antennas for continuous-wave terahertz emission", IEEE J. Quantum Electronics, Vol. 41, 717 (2005)).

Eine ähnliche Anordnung aus einen Photoleiter mit einer LT photoleitenden Halbleiterschicht oberhalb einer Halbleitergrenzschicht auf einem Substrat ist in der Druckschrift US 2003/0127673 A1 offenbart. Zwei Elektroden sind mit der photoleitenden Halbleiterschicht für einen lateralen Stromfluss zwischen den Elektroden verbunden. Als Photoleiter wird das bekannte "low temperature" GaAs (LT-GaAs) genutzt, auf das Kontakte für einen lateralen Stromfluss aufgebracht werden. Wesentlicher Inhalt der US 2003/0127673 A1 ist Design und Integration von elektrischen Verstärkern mit dem Photoleiter zu einem sogenannten "Amplified Photoconductive Gate". Es soll der Stand der Technik mit klarem Festhalten am Prinzip "low temparture" (LT) Photoleiter verbessert werden und durch zusätzliche Barriereschichten aus AlGaAs zwischen dem LT-Photoleiter und dem Substrat verbessert werden.

Eine derartige Barriereschicht ist auch gemäß Druckschrift WO 2006/063233 A vorgesehen, die einen photoleitenden Schalter mit einer "low temperature" (LT) epitaktisch gewachsenen photoleitenden Halbleiterschicht auf einem GaAs- oder InP-Substrat offenbart. Auf der LT photoleitenden Schicht ist eine Barriereschicht (cap layer) aufgewachsen. "Barriere" bedeutet, dass diese Schichten einen größeren Bandabstand haben, so dass Ladungsträger eine Energieschwelle überwinden müssen, um in das Barrierematerial zu gelangen. Durch die Barrieren soll gemäß WO 2006/063233 A ein Dunkelstrom zwischen Kontakten über die photoleitende Schicht verhindert werden. Gemäß US 2003/0127673 A1 soll durch die Barriere eine Diffusion der Photoladungsträger in das Substrat verhindert werden. Diese Funktion einer Schicht mit höherem Bandabstand, nämlich als Barriere zu wirken, um die Ladungsträger zusammenzuhalten, wird als "elektrisches confinement" bezeichnet, ist gut bekannt, klar definiert und wird bei vielen optischen Bauelementen eingesetzt.

Eine grundsätzliche nachteilige Folge dieser Technik ist, dass die Beweglichkeit von Ladungsträgern im Photoleiter erheblich abnimmt, da die Störstellen auch als Streuzentren für die freien Ladungsträger wirken. Eine weitere negative Folge der Kristalldefekte im Halbleiter ist, dass Bandkanten von Energiebändern verschliffen und unscharf werden, und so das Absorptionsverhalten bei Lichteinstrahlung in diesem Spektral-Bereich ungünstiger wird.

GaAs ist nur im Spektralbereich mit Wellenlängen unterhalb von 850 nm empfindlich und einsetzbar. Ein spezielles Problem für den exemplarischen Spektralbereich mit Wellenlängen von 1 µm bis 1,6 µm ergibt sich deshalb daraus, dass sich das hier als Photoleiter geeignete Ausgangsmaterial InGaAs auf InP (Indiumphosphid) bei LT-Wachstum teilweise anders verhält als das LT-GaAs. Es entstehen zwar einerseits auch hier die benötigten Kristalldefekte für ein Einfangen der Elektronen und eine schnelle Rekombination, aber parallel dazu steigen Ladungsträgerkonzentration und Dunkelleitfähigkeit so stark an (siehe H. Künzel, J. Böttcher, R. Gibis, and G. Urmann, "Material Properties of In0,53 Ga0,47 As on InP by Low-Temperature Molecular Beam Epitaxy" Appl. Phys. Lett. Vol. 61, 1347 (1992)), dass ein Einsatz z.B. in THz-Antennen nicht mehr sinnvoll ist. Es wurden deshalb für das Materialsystem InGaAs auf InP alternative Techniken zur Erzeugung von Kristalldefekten und schnellen Rekombinationszentren entwickelt, z.B. die Implantation von Fe-Atomen (siehe M. Suzuki and M. Tonouchi, "Fe-implanted InGaAs photoconductive terahertz detectors triggered by 1.56 µm femtosecond otpical pulses", Appl. Phys. Lett., Vol 86, 163504 (2005) oder der Beschuss mit Br-Ionen (siehe N. Chimot, J. Mangeney, L. Joulaud, P. Crozat, H. Bernas, K. Blary, and J.F. Lampin, "Terahertz radiation from heavy-ion-irradiated In0.53Ga0.47As photoconductive antenna excited at 1.55 µm" Appl. Phys. Lett. Vol.87, 193510 (2005)). Vergleichbar gute Ergebnisse wie mit LT-GaAs wurden aber nicht erreicht, und so gibt es zur Zeit keine akzeptablen auf Photoleitern basierenden THz-Antennen für den Spektralbereich bei 1.5 µm Wellenlänge, der umgekehrt sehr attraktiv ist, da hier preisgünstige Halbleiterlaser und vielfältige Faser-Komponenten zur Verfügung stehen.

LT-Wachstum von InGaAs auf GaAs wurde ebenfalls versucht (C.Baker, I.S. Gregory, M.J. Evans, W.R. Tribe, E.H. Linfield, M. Missous, "All-optoelectronic terahertz system u-sing low-temperature-grown InGaAs photomixers", Optics Express Vol.13, 9639, (2005)), wobei in diesem Materialsystem aber der Wellenlängenbereich nur gering über 1 µm hinaus geschoben werden kann, und im Vergleich zu LT-GaAs wurden deutlich schlechtere Eigenschaften erreicht.

Die Aufgabe der vorliegenden Erfindung besteht somit darin, einen Photoleiter mit verbesserten Eigenschaften in Bezug auf Beweglichkeit von Ladungsträgern und Dunkelleitfähigkeit zu schaffen, der auch für einen Wellenlängenbereich bis 2 µm geeignet ist.

Diese Aufgabe wird durch einen Photoleiter gemäß Patentanspruch 1 und ein Verfahren zum Herstellen eines Photoleiters gemäß Patentanspruch 11 gelöst. Ferner schafft die vorliegende Erfindung eine photoleitende Antenne zum Senden und/oder Empfangen von THz-Strahlung basierend auf einem erfindungsgemäßen Photoleiter.

Die Erkenntnis der vorliegenden Erfindung besteht darin, dass eine hohe Beweglichkeit von Ladungsträgern und eine geringe Dunkelleitfähigkeit erreicht werden kann, indem abwechselnd verschiedene Halbleiterschichten unterschiedlicher Zusammensetzung und unterschiedlicher Eigenschaften auf ein isolierendes bzw. semi-isolierendes Halbleitersubstrat aufgebracht werden. Dabei wird ein im gewünschten Wellenlängenbereich photoleitendes Halbleitermaterial zwischen Halbleitergrenzschichten mit einem größerem Bandabstand eingebettet, d.h. einem größerem energetischen Abstand zwischen Valenzband und Leitungsband, wobei in den Grenzschichten Kristallgitterstörstellen zum Einfangen freier Photoladungsträger und für eine anschließende schnelle Rekombination eingebaut werden.

Erfindungsgemäß wird die photoleitende Halbleiterschicht sehr dünn gehalten, beispielsweise in einem Bereich kleiner 30 nm (Nanometer) und noch mehr bevorzugt in einem Bereich kleiner 20 nm oder kleiner 15 nm. Freie Photoladungsträger können hierdurch die benachbarten Halbleitergrenzschichten und deren tiefe Kristallgitterstörstellen senkrecht zur Schichtebene auf kurzem Weg und somit schnell erreichen.

Gemäß Ausführungsbeispielen wird eine periodische Wiederholung der Halbleitergrenzschicht, der photoleitenden Halbleiterschicht und der Halbleitergrenzschicht in der Halbleiterschichtstruktur verwendet, wodurch ein effektiverer und größerer Photoeffekt erzielt wird.

Die Photoleitung einerseits und das Einfangen und Rekombinieren der Photoladungsträger andererseits sind aufgrund der Anordnung der Halbleiterschichten räumlich getrennt und laufen in unterschiedlichen Halbleiterschichten ab. Die unterschiedlichen Schichten können somit individuell für ihre jeweilige Funktion optimiert werden, wobei die Optimierung einer Schicht dabei nicht die Funktion der jeweils anderen Schicht beeinträchtigt.

Ein Vorteil der vorliegenden Erfindung besteht somit darin, dass mit einem gemäß dem erfindungsgemäßen Konzept realisierter Photoleiter aus verschiedenen Halbleiterschichten, ein hoher Dunkelwiderstand, eine hohe Photoempfindlichkeit bei bestimmten Wellenlängen, eine hohe Beweglichkeit der erzeugten Photoladungsträger bei Lichteinfall und ein schnelles Abklingen in den isolierenden Zustand nach Abschalten der Beleuchtung erreicht werden kann.

Vorteilhafte Ausgestaltungen und Weiterbildungen sind Gegenstand der Unteransprüche.

Bevorzugte Ausführungsbeispiele der vorliegenden Erfindung werden nachfolgend Bezug nehmend auf die beiliegenden Zeichnungen näher erläutert. Es zeigen:
- Fig. 1: eine schematische Darstellung des Frequenzspektrums zur Veranschaulichung der Lage des THz-Gebietes;
- Fig. 2: eine schematische Darstellung zur Erläuterung einer möglichen Erzeugung von THz-Strahlung;
- Fig. 3: einen Querschnitt einer möglichen Photoleiter-Struktur;
- Fig. 4: eine schematische Darstellung einer photoleitenden Antenne;
- Fig. 5: ein Flussdiagramm zur Erläuterung eines Verfahrens zum Herstellen eines Photoleiters gemäß einem Ausführungsbeispiel der vorliegenden Erfindung;
- Fig.6a-d: Darstellungen verschiedener Verfahrensschritte zur Herstellung eines Photoleiters gemäß einem weiteren Ausführungsbeispiel der vorliegenden Erfindung;
- Fig. 7: einen Photoleiter mit Elektroden gemäß einem Ausführungsbeispiel der vorliegenden Erfindung;
- Fig. 8: eine Photoleiterstruktur mit einer mit Lichtwellenleitern gekoppelten Photoleiterschicht, gemäß einem Ausführungsbeispiel der vorliegenden Erfindung;
- Fig. 9: einen Photoleiter mit Halbleiterschichtstapel gemäß einem weiteren Ausführungsbeispiel der vorliegenden Erfindung; und
- Fig. 10a: eine Darstellung verschiedener Eigenschaften
- - 10c: von InGaAs eingebettet in InAlAs aufgetragen über der Wachstumstemperatur.

Bezüglich der nachfolgenden Beschreibung sollte beachtet werden, dass bei den unterschiedlichen Ausführungsbeispielen gleich oder gleichwirkende Funktionselemente gleiche Bezugszeichen aufweisen und so die Beschreibungen dieser Funktionselemente in den verschiedenen im Nachfolgenden dargestellten Ausführungsbeispielen untereinander austauschbar sind.

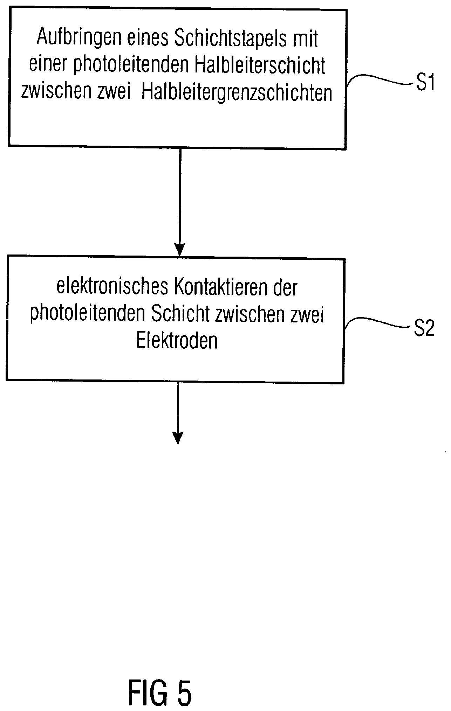

Fig. 5 zeigt schematisch ein Flussdiagramm zur Erläuterung eines Verfahrens zum Herstellen eines Photoleiters gemäß einem Ausführungsbeispiel der vorliegenden Erfindung.

In einem ersten Schritt S1 wird auf ein Substrat ein Schichtstapel mit einer für einen vorbestimmten Wellenlängenbereich photoleitenden Halbleiterschicht zwischen zwei Halbleitergrenzschichten mit einem größeren Bandabstand als die photoleitende Halbleiterschicht aufgebracht, wobei die Halbleitergrenzschichten energetisch tiefe Störstellen zum Einfangen und zur Rekombinination von freien Ladungsträgern aus der photoleitenden Halbleiterschicht aufweisen. In einem zweiten Schritt S2 wird die photoleitende Halbleiterschicht mit zwei Elektroden für einen lateralen Stromfluss zwischen den Elektroden durch die photoleitende Halbleiterschicht kontaktiert.

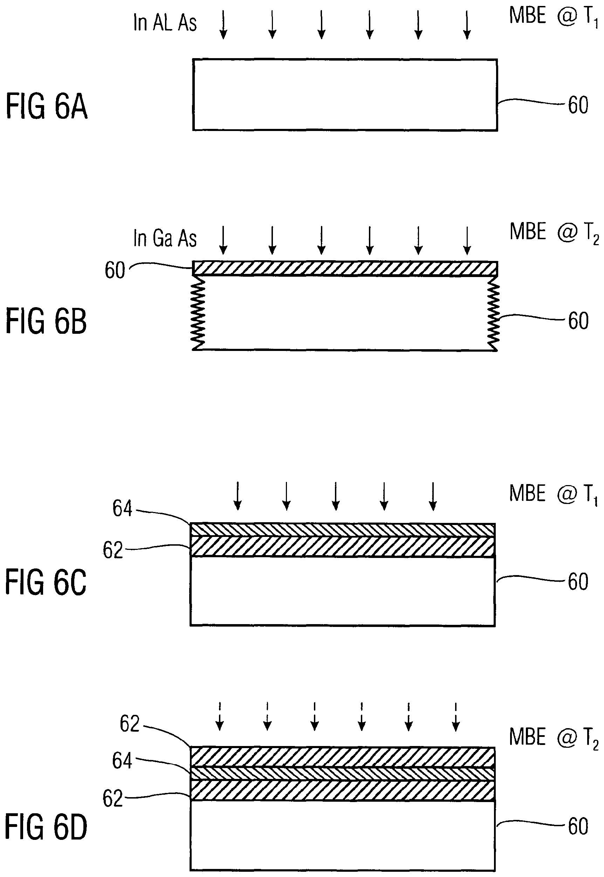

Das Aufbringen des Schichtstapels auf das Substrat im Schritt S1 soll im Nachfolgenden anhand der Figuren 6a bis 6d näher erläutert werden.

Fig. 6a zeigt ein Halbleitersubstrat 60, welches gemäß Ausführungsbeispielen der vorliegenden Erfindung ein InP-Halbleitersubstrat (InP = Indium-Phosphid) oder ein GaAs-Halbleitersubstrat sein kann.

In einem in Fig. 6a skizzierten ersten Schritt wird durch ein epitaktisches Aufwachsen bei einer ersten Temperatur T₁ eine erste Halbleitergrenzschicht 62 auf das Halbleitersubstrat 60 aufgewachsen. Das epitaktische Aufwachsen wird dabei durch eine sogenannte Molekularstrahlepitaxie (MBE = Molecular Beam Epitaxy) bewerkstelligt. Gemäß Ausführungsbeispielen handelt es sich bei dem Halbleitermaterial für die erste Halbleitergrenzschicht 62 um InAlAs (Indium-Aluminium-Arsenid).

Nachdem die erste Halbleitergrenzschicht 62 bei der ersten Temperatur T₁ durch Molekularstrahlepitaxie auf das Substrat 60 aufgewachsen wurde, wird in einem in Fig. 6b gezeigten nächsten Schritt ein photoleitendes Halbleitermaterial durch Molekularstrahlepitaxie bei einer zweiten Temperatur T₂ auf die erste Halbleitergrenzschicht 62 aufgewachsen. Gemäß Ausführungsbeispielen handelt es sich bei der photoleitenden Halbleiterschicht 64 um eine Halbleiterschicht aus InGaAs (Indium-Gallium-Arsenid) oder InGaAsP (Indium-Gallium-Arsenid-Phosphid).

In einem weiteren in Fig. 6c dargestellten Schritt wird wiederum bei der ersten Temperatur T₁ eine weitere Halbleitergrenzschicht 62 auf die photoleitende Halbleiterschicht 64 durch Molekularstrahlepitaxie aufgewachsen. Dadurch entsteht ein Schichtstapel mit der für den vorbestimmten Wellenlängenbereich photoleitenden Halbleiterschicht 64 zwischen den zwei Halbleitergrenzschichten 62, welche einen größeren Bandabstand als die photoleitende Halbleiterschicht 64 aufweisen.

Die Temperaturen T₁ und T₂ werden gemäß Ausführungsbeispielen so gewählt, dass die photoleitende Halbleiterschicht 64 bei möglichst guter Kristallqualität mit wenigen Störstellen wächst, während in die Halbleitergrenzschichten 62 gezielt tiefe Störstellen eingebaut werden, die freie Ladungsträger aus der photoleitenden Halbleiterschicht 62 schnell (vorzugsweise im ps- oder sub-ps-Bereich) einfangen und zur Rekombination bringen.

Die elektrischen Eigenschaften eines Halbleiters werden neben den intrinsischen physikalischen Eigenschaften des reinen Kristalls wesentlich durch Energieniveaus in der Lücke zwischen Leitungs- und Valenzband bestimmt. Diese Energieniveaus entstehen beispielsweise durch gezielte Störungen des Kristallgitters bei der Herstellung des Halbleitermaterials. Im Gitter anwesende Störstellen können Elektronen aus dem Valenzband aufnehmen (Akzeptoren) oder Elektronen an das Leitungsband abgeben (Donatoren). Dadurch entstehen zusätzliche Löcher und Elektronen, die ganz gezielt die elektrischen Eigenschaften des Halbleiters verändern. Liegen die Energieniveaus der Störstellen ungefähr in der Mitte des verbotenen Bandes, spricht man von tiefen Störstellen. Bei einer Temperatur von ca. 300 K (Kelvin) weisen die tiefen Störstellen gemäß Ausführungsbeispielen einen Abstand, der größer oder gleich 30 Milli-Elektronenvolt (meV) ist, zum Leitungs- und zum Valenzband auf.

Betrachtet man die photoleitende Halbleiterschicht 64 isoliert, d.h. getrennt von den Halbleitergrenzschichten 62, quasi im ungestörten Zustand, so weist das Material der photoleitenden Halbleiterschicht 64 eine bestimmte Konzentration der freien Ladungsträger bei beispielsweise 300 K auf, und die Konzentration der tiefen Störstellen in den Halbleitergrenzschichten 62 muss nun gleich oder größer als die Konzentration der freien Ladungsträger in der photoleitenden Halbleiterschicht 64 sein, d.h. das Verhältnis der tiefen Störstellen in den Halbleitergrenzschichten 62 zu der Konzentration der freien Ladungsträger in der photoleitenden Halbleiterschicht 64 ist vorzugsweise größer oder gleich Eins.

Erfindungsgemäß wird die photoleitende Halbleiterschicht 64 sehr dünn gehalten, beispielsweise in einem Bereich von 3 bis 30 nm, derart, dass durch Lichteinfall erzeugte freie Photoladungsträger die Halbleitergrenzschichten 62 und deren tiefe Störstellen senkrecht zur Schichtebene auf kurzem Weg und somit schnell erreichen können.

Um einen ausreichend effektiven und großen Photoeffekt erzielen zu können, kann die Schicht-Abfolge aus erster Halbleitergrenzschicht 62, photoleitender Schicht 64 und zweiter Halbleitergrenzschicht 62 periodisch wiederholt werden. Bezug nehmend auf Fig. 6d bedeutet dies, dass auf die obere Halbleitergrenzschicht 62 durch Molekularstrahlepitaxie wiederum eine photoleitende Halbleiterschicht 64 bei der Temperatur T₂ aufgebracht würde, gefolgt von einer molekularstrahlepitaktischen Aufwachsung einer weiteren Halbleitergrenzschicht 62 bei der Temperatur T₁ u.s.w.

Die Schichtreihenfolge der Halbleiterschichten innerhalb des Schichtstapels kann natürlich auch anders gewählt werden. Beispielsweise könnte auf das Substrat 60 zuerst eine photoleitende Halbleiterschicht 64, danach eine Halbleitergrenzschicht 62 und darauffolgend wieder eine photoleitende Halbleiterschicht 64 u.s.w. aufgebracht werden. Das gleiche gilt für die abschließende Schicht. Sie kann entweder eine der Grenzschichten 62 oder eine der Photoleitenden Schichten 64 sein.

Für eine Realisierung einer photoleitenden THz-Antenne, werden nach oder bereits während der Herstellung des Schichtstapels insbesondere die photoleitenden Halbleiterschichten 64 mit Elektroden leitend verbunden, so dass bei Anlegen einer Spannung an die Elektroden und Lichteinfall in dem vorbestimmten Wellenlängenbereich ein lateraler Stromfluss zwischen den Elektroden durch die photoleitende(n) Halbleiterschicht(en) 64 ermöglicht wird.

Bei der Verwendung der im Vorhergehenden bereits genannten Halbleitermaterialien, d.h. InGaAs oder InGaAsP als photoleitendes Material und InAlAs für die Halbleitergrenzschichten 62, liegt der vorbestimmte Wellenlängenbereich des Lichts, bei dem in der photoleitenden Schicht 64 Elektronen aus dem Valenzband in das Leitungsband angehoben werden, in einem Bereich von 0,5 µm bis 2 pm, insbesondere in einem Bereich von 1 µm bis 1,6 µm.

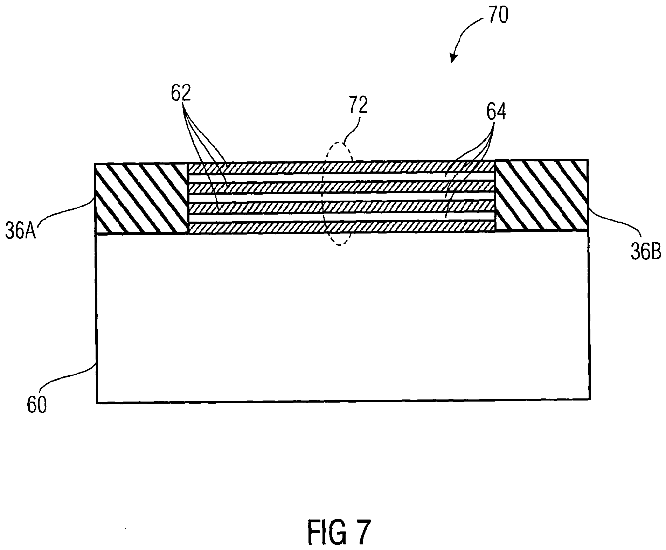

Eine durch das im Vorhergehenden beschriebene Verfahren hergestellte Photoleiterstruktur, gemäß einem Ausführungsbeispiel der vorliegenden Erfindung, ist in Fig. 7 gezeigt.

Fig. 7 zeigt eine Photoleiterstruktur 70 auf einem Halbleiter-Substrat 60 mit vier Halbleitergrenzschichten 62, zwischen die jeweils eine photoleitende Halbleiterschicht 64 eingebettet ist. Der Schichtstapel 72 aus den Halbleitergrenzschichten 62 und den photoleitenden Halbleiterschichten 64 ist an gegenüberliegenden Seiten des Schichtstapels mit Elektroden 36a,b kontaktiert, um bei Anlegen einer Spannung an die Elektroden 36a,b einen lateralen Stromfluss durch die photoleitenden Halbleiterschichten 64 zu ermöglichen. Fig. 7 zeigt eine bevorzugte Variante mit periodischer Schichtfolge für einen Multiplikationseffekt der dünnen Schichten und mit einer sog. Mesa-Struktur mit seitlichen Kontakten bzw. Elektroden 36a,b. Durch diese seitlichen Kontakte 36a,b sollen alle Schichten - auch die tiefer liegenden - direkt mit einem Metallkontakt verbunden werden, ein Strompfad somit also überall gleich kurz sein.

Im Gegensatz zu dem in Fig. 7 gezeigten Ausführungsbeispiel könnten gemäß Ausführungsbeispielen sowohl die erste Elektrode 36a als auch die zweite Elektrode 36b jeweils nur mit den photoleitenden Halbleiterschichten 64 verbunden sein.

Werden die Elektroden 36a,b jeweils, wie anhand von Fig. 4 beschrieben wurde, mit metallischen Leiterstreifen 32a,b, gekoppelt, so kann mit der in Fig. 7 gezeigten Struktur eine erfindungsgemäße THz-Antenne realisiert werden, wobei ein erfindungsgemäßer photoleitender Schichtstapel 72 an die Stelle der massiven Photoleitschicht 42 tritt. Des weiteren kann ein herkömmliches Halbleitersubstrat 40 ggf. durch ein Halbleitersubstrat 60 gemäß einem Ausführungsbeispiel der vorliegenden Erfindung, d.h. ein InP- oder GaAs-Halbleitersubstrat, ersetzt oder ergänzt werden. Besonders vorteilhaft ist dabei die bereits beschriebene Mesa-Struktur.

Durch die Verlagerung des Einfangens und der Rekombination der Photo-Ladungsträger von der Photoleiterschicht in die angrenzenden Halbleitergrenzschichten 62 ist eine hohe kristalline Qualität der Photoleitungsschicht 64 möglich, und so können eine hohe Beweglichkeit der freien Photoladungsträger und eine definierte Bandkante erhalten bleiben. Wichtig ist, dass die photoleitende Schicht 64 ausreichend dünn ist, damit die freien Photoladungsträger senkrecht zur Schichtebene auf kurzem Weg und damit sehr schnell die Grenzschichten 62 erreichen, wo sie durch tiefe Störstellen eingefangen werden und anschließend rekombinieren.

Es können hierfür - ja nach Anforderung - sehr dünne Schichten im Bereich weniger Nanometer erforderlich sein. Die Licht-Absorption in einer solch dünnen durchstrahlten Schicht ist gering.

Die Effizienz des Photo-Effekts kann zusätzlich durch zwei unterschiedliche Maßnahmen wesentlich verbessert werden.

Es kann zur Multiplikation des Effektes ein Schichtpaket 72 mit abwechselnd dünnen photoleitenden Schichten 64 und Grenzschichten 62 mit den Rekombinationszentren genutzt werden. Die effektive Gesamtdicke bezüglich der Licht-Absorption und der Photoleitung wird dadurch vergrößert, während eine dünne Einzelschicht jeweils ihre Eigenschaften behält.

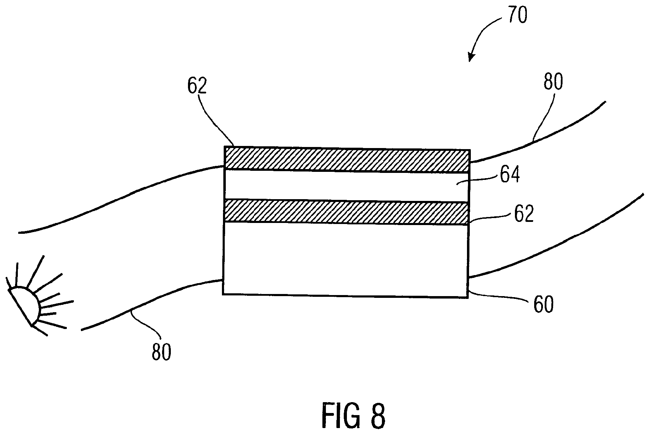

Es kann seitlich parallel zur Schichtebene eingestrahlt werden, womit Schichtdicke und Absorptionslänge grundsätzlich entkoppelt voneinander sind. Das Einkoppeln des Lichtes in eine dünne Schicht stellt hier ein Problem dar. Dies kann aber gelöst werden, wenn die photoleitende Schicht 64 beispielsweise mit einem Licht-Wellenleiter integriert wird, wie es schematisch in Fig. 8 gezeigt ist.

Fig. 8 zeigt eine erfindungsgemäße Photoleiterstruktur 70 mit auf einem Substrat 60 aufgebrachten Halbleiterschichten 62, 64, 62, wobei die photoleitende Halbleiterschicht 64 beidseitig mit einem Lichtwellenleiter 80 verbunden ist.

Ein externes Lichtsignal kann zunächst sehr effizient in die (dicke) Wellenleiterstruktur 80 eingekoppelt werden. Das geführte Licht trifft dann auf die integrierte photoleitende Schicht 64 und wird dort sukzessive und effizient absorbiert.

Die beiden im Vorhergehenden beschriebenen Maßnahmen können auch durch seitliche Lichteinstrahlung in ein Schichtpaket 72 kombiniert werden.

Ein guter photoleitender Halbeiter für den Spektralbereich bis 1,65 µm Wellenlänge und mit hoher Ladungsträger-Beweglichkeit ist InGaAs auf InP. Ein besonders geeignetes Material für die Halbleitergrenzschichten 62 ist InAlAs, das auch gitter-angepasst auf InP gewachsen werden kann. InAlAs hat - wie gefordert - einen größeren Bandabstand als InGaAs, ist damit transparent im Spektralbereich für Wellenlängen größer als 1 pm, und zeigt ein sehr hoch isolierendes Verhalten, erzeugt also keine Strompfade parallel zur Photoleiterschicht 64. Weiterhin werden beim Tieftemperaturwachstum - ähnlich wie im GaAs - sehr effektive und schnelle Rekombinationszentren verursacht.

Eine dünne Photoleiterschicht 64 aus InGaAs bei einer Temperatur T₂ oberhalb von 200°C gewachsen und somit guter kristalliner Qualität und Beweglichkeit, eingebettet in Grenzschichten aus InAlAs, gewachsen bei einer Temperatur T₁ unterhalb von 200°C und somit aufzeigend schnelle Rekombinationszentren, entspricht einem bevorzugten Ausführungsbeispiel der vorliegenden Erfindung.

Das epitaktische Wachstum mit variierten Temperaturen T₁ und T₂ erschwert jedoch den Herstellungsprozess. Vereinfachte Strukturen mit gleichbleibender Wachstumstemperatur, d.h. T₁ = T₂, für die Grenzschichten 62 und die photoleitende Schicht 64 sind deshalb auch von Interesse. Hier zeigt das bevorzugte Grenzschichtmaterial InAlAs eine weitere interessante Eigenschaft. Wird nämlich InAlAs mit der Molekularstrahlepitaxie bei Temperaturen T₁ im Bereich 350-500°C gewachsen, so entstehen dort direkt beim Wachstum und ohne weitere Behandlung die benötigten Trapping- und Rekombinationszentren. Das vereinfachte Wachstum eines InGaAs/InAlAs-Schichtstapels bei einheitlicher Temperatur in diesem Bereich 350 - 500°C führt also zu guter kristalliner Qualität der Photoleiterschicht 64 und damit hoher Beweglichkeit und gleichzeitig zur Ausbildung von Kristalldefekten in den Grenzschichten 62 für Einfang und Rekombination der Elektronen aus der Photoleiterschicht 64.

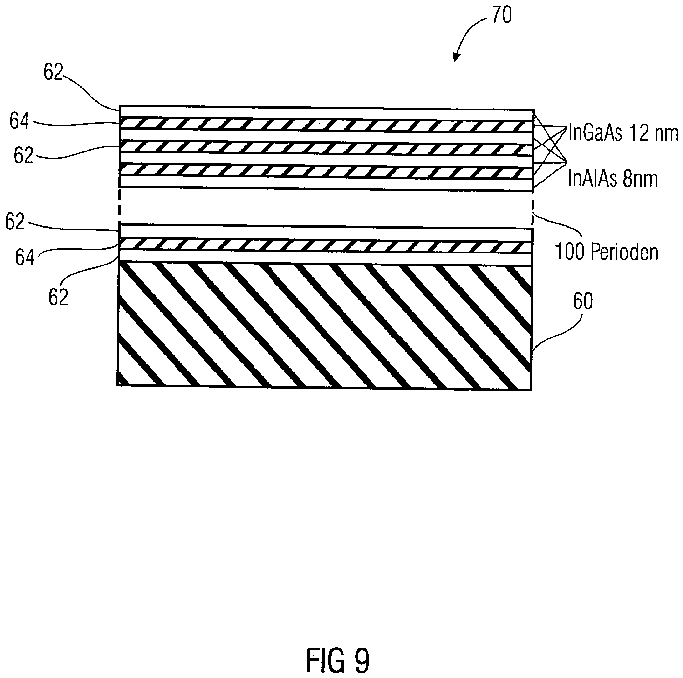

Analog zum in Fig. 9 gezeigten Schema wurden Photoleiterstrukturen aus 100 Perioden mit abwechselnd 12 nm dicken InGaAs Photoleiterschichten und 8 nm dicken InAlAs Grenzschichten bei verschiedenen gleichbleibenden Wachstumstemperaturen T = T₁ = T₂ mit der Molekularstrahlepitaxie gewachsen.

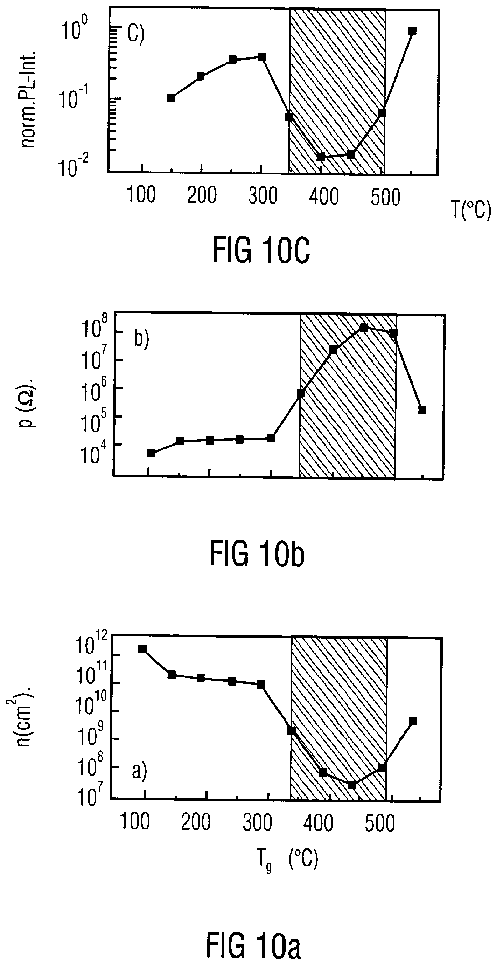

In Fig. 10a sind Ladungsträgerdichte bzw. -konzentration, in Fig. 10b spezifischer elektrischer Widerstand ρ und in Fig. 10c integrale Photolumineszenz einer InGaAs-Photoleiterschicht 64 über der Wachstumstemperatur T = T₁ = T₂ dargestellt.

Erkennbar ist, dass durch Wachstum im Bereich 350 - 500°C die Ladungsträgerkonzentration n stark abfällt (Fig. 10a) und der spezifische Widerstand ρ um Größenordnungen ansteigt (Fig. 10b). Die Lumineszenzintensität bricht ebenfalls in diesem Bereich ein (Fig. 10c). Es handelt sich hier um den Einfluss der Grenzschichten 62 und der tiefen Störstellen in diesen auf die freien Ladungsträger in den InGaAs Photoleiterschichten 64. Die freien Ladungsträger werden weggefangen, was zu geringer Ladungsträgerkonzentration n und hohem Widerstand ρ führt. Die Elektronen rekombinieren dann nichtstrahlend und schnell über die tiefen Störstellen, was an der geringen Lumineszenzintensität des InGaAs erkennbar ist. Die Beweglichkeit der Elektronen in den InGaAs Photoleiterschichten 64 wird nur gering durch die Störstellen in den Grenzschichten 62 beeinträchtigt. Mit den bei 400°C gewachsenen Strukturen konnten so sehr gute Elektronenbeweglichkeiten von 4000 cm²/Vs mit Schichtwiderständen nahe 10 MΩ kombiniert werden. Das Ausführungsbeispiel belegt die Funktion des erfindungsgemäßen Konzepts, die tiefen Störstellen von der Photoleiterschicht 64 weg in die Grenzschichten 62 zu verlagern.

In einer anderen Ausführungsform, die ebenfalls vorteilhaft ist, weil sie vereinfacht bei einheitlicher Wachstumstemperatur realisiert wird, wird das InGaAs/InAlAs Schichtpaket einheitlich unterhalb einer Temperatur von 200°C gewachsen. Die Photoleiterschicht 64 hat hier zwar nicht ihre optimale Beweglichkeit, aber auch unter diesen Bedingungen führt der Einfluss der Grenzschichten 62 zu erheblichen Vorteilen, was basierend auf einer Wachstumsserie experimentell festgestellt wurde. Diese Wachstumsserie wurde bei einer Temperatur von 130°C durchgeführt, und ausgehend von den bekannten InGaAs Photoleitern wurde untersucht, welche Verbesserungen sich durch das erfindungsgemäße Konzept, d.h. die Einführung dünner Schichten 64 und deren Einbettung zwischen InAlAs Grenzschichten 62, erreichen lassen. Bei dieser Wachstumsserie wurde auch das bekannte Verfahren einer Be-Dotierung (Be = Beryllium) eingesetzt, wobei die Be-Dotierung konstant durch das ganze Schichtpaket und gleich für alle gewachsenen Strukturen ist. Die Be-Dotierung wirkt dabei als Akzeptor und kompensiert freie Elektronen teilweise.

Bei identischen Herstellungsbedingungen und sonst vergleichbarer Struktur konnte festgestellt werden, dass nur durch dünner werdende Photoleiterschichten 64 gegenüber den Grenzschichten 62 die Schichtladungsträgerkonzentration von 1*10¹² cm⁻² (1 µm dicke massive Schicht) über 6*10¹⁰ cm⁻² (20 nm dünne eingebettete Photoleiterschichten) auf 2*10¹⁰ cm⁻² (12 nm dünne eingebettete Photoleiterschichten) und 1*10¹⁰ cm⁻² (6 nm dünne eingebettete Photoleiterschichten) reduziert und entsprechend der Schichtwiderstand von 50 kΩ/sq bzw. 50 kΩ/□ über 130 kΩ/sq auf 600 kΩ/sq und 1,4 MΩ/sq erhöht werden kann. Durch Be-Dotierung optimierte massive LT InGaAs Schichten können also durch einen Einfluss der Grenzschichten 62 noch einmal in erheblichem Maße verbessert werden. Diese Ergebnisse sind in Tab. 1 zusammengefasst.

**Tab.1**

| Material Be-Dotierung Wachstum bei 130°C | Schichtladungsträgerkonzentration. N/cm⁻² | Schichtwiderstand R_{S} (Ω/sq) |
|---|---|---|
| Massiv InGaAs | 10¹² | 50.000 |
| 20nm InGaAs/InAlAs | 6*10¹⁰ | 130.000 |
| 12nm InGaAs/InAlAs | 2*10¹⁰ | 600.000 |
| 6nm InGaAs/InAlAs | 1*10¹⁰ | 1.400.000 |

Etwas anders ausgedrückt kann ein Schichtwiderstandswert eines gegebenen Materials - hier InGaAs - um ein bis zwei Größenordnungen gesteigert werden - hier von 50.000 Ω/sq auf 1.400.000 Ω/sq - durch Einbetten des Materials als dünne Schicht zwischen Halbleitergrenzflächen mit höherem Bandabstand und mit tiefen Störstellen.

Auf die in Fig. 9 dargestellte erfindungsgemäße Photoleiterstruktur mit 12 nm Photoleiterdicke, 8 nm Grenzschichtdicke und 100 Perioden können Antennen bzw. Leiterbahnen für Abstrahlung und Empfang von THz Strahlung aufgebracht werden. Die Antennen können beispielsweise in einem sog. "Time Domain"-Spektrometer mit Puls-Anregung bei 1,55 µm eingesetzt und THz Emission und Detektion für Frequenzen bis jenseits von 2 THz demonstriert werden.

Mit diesen Ergebnissen bedeuten erfindungsgemäße InGaAs Photoleiter mit InAlAs Grenzschchichten einen Durchbruch bei photoleitenden THz Antennen für den Wellenlängenbereich bei 1,55 µm. Durch das erfindungsgemäße Konzept können Photoleiter zur Erzeugung und Detektion von THz-Strahlung durch photoleitende Antennen oder Photomischer bereitgestellt werden, die ohne Beleuchtung elektrisch isolierend sind, eine hohe Photoempfindlichkeit im vorbestimmten Wellenlängenbereich, eine hohe Beweglichkeit von erzeugten Photoladungsträgern und ein schnelles Abklingen in den isolierenden Zustand nach Abschalten der Beleuchtung aufweisen.

Abschließend ist darauf hinzuweisen, dass die vorliegende Erfindung nicht auf einen beschriebenen Aufbau oder die erläuterte Vorgehensweise zur Herstellung beschränkt ist, da Aufbau und Herstellung der Photoleiterstruktur variieren können. Die hier verwendeten Begriffe sind lediglich dafür bestimmt, besondere Ausführungsformen zu beschreiben und werden nicht einschränkend verwendet. Wenn in der Beschreibung und in den Ansprüchen die Einzahl oder unbestimmte Artikel verwendet werden, beziehen sich diese auch auf die Mehrzahl dieser Elemente, solange nicht der Gesamtzusammenhang eindeutig etwas anderes deutlich macht. Dasselbe gilt in umgekehrte Richtung.

Gemäß einem Ausführungsbeispiel umfasst ein Photoleiter einem Schichtstapel 72 mit einer für einen vorbestimmten Wellenlängenbereich photoleitenden Halbleiterschicht 64 zwischen zwei Halbleitergrenzschichten 62 mit einem größeren Bandabstand als die photoleitende Halbleiterschicht 64 auf einem Substrat 60, wobei die Halbleitergrenzschichten 62 tiefe Störstellen zum Einfangen und zur Rekombinination von freien Ladungsträgern aus der photoleitenden Halbleiterschicht 64 aufweisen und wobei die photoleitende Halbleiterschicht 6) eine Dicke in einem Bereich kleiner 30 nm aufweist; und zwei Elektroden 36a,b, die mit der photoleitenden Halbleiterschicht 64 verbunden sind, für einen lateralen Stromfluss zwischen den Elektroden 36a,b durch die photoleitende Halbleiterschicht 64. Dabei kann sich der Schichtstapel 72 aus einer photoleitenden Halbleiterschicht 64 zwischen zwei Halbleitergrenzschichten 62 periodisch wiederholen.

Bei einem bevorzugten Ausführungsbeispiel des Photoleiters liegt der vorbestimmte Wellenlängenbereich in einem Bereich von 0,5 µm bis 2 µm.

Bei einem bevorzugten Ausführungsbeispiel des Photoleiters ist die photoleitende Schicht 64 mit einem Lichtwellenleiter 80 gekoppelt, so das über den Lichtwellenleiter 80 Licht lateral in die photoleitende Schicht 64 eingestrahlt werden kann.

Gemäß einem Ausführungsbeispiel des Verfahrens zum Herstellen eines Photoleiters, wird als Substrat ein InP- oder GaAs-Halbleitersubstrat verwendet.

## Patentansprüche

1. Photoleiter mit folgenden Merkmalen:
einem Schichtstapel (72) mit einer für einen vorbestimmten Wellenlängenbereich photoleitenden Halbleiterschicht (64) zwischen zwei Halbleitergrenzschichten (62) mit einem größeren Bandabstand als die photoleitende Halbleiterschicht (64) auf einem Substrat (60), wobei die Halbleitergrenzschichten (62) tiefe Störstellen zum Einfangen und zur Rekombinination von freien Ladungsträgern aus der photoleitenden Halbleiterschicht (64) aufweisen und wobei die photoleitende Halbleiterschicht (64) eine Dicke in einem Bereich kleiner 30 nm aufweist; und
zwei Elektroden (36a,b), die mit der photoleitenden Halbleiterschicht (64) verbunden sind, für einen lateralen Stromfluss zwischen den Elektroden (36a,b) durch die photoleitende Halbleiterschicht (64),
**dadurch gekennzeichnet, dass**
die Halbleitergrenzschichten (62) eine Konzentration der tiefen Störstellen aufweisen, die größer oder gleich einer Konzentration von freien Ladungsträgern in der photoleitenden Halbleiterschicht (64) ohne eine Wirkung der Halbleitergrenzschichten (62) ist.

2. Photoleiter gemäß Anspruch 1, wobei der Schichtstapel (72) als Mesa-Struktur ausgebildet ist mit seitlicher Kontaktierung der photoleitenden Halbleiterschicht (64) durch die Elektroden (36a,b).

3. Photoleiter gemäß Anspruch 1 oder 2, wobei das Substrat ein InP- oder GaAs-Halbleitersubstrat ist.

4. Photoleiter gemäß einem der vorhergehenden Ansprüche, wobei die photoleitende Halbleiterschicht (64) ein InGaAs- oder InGaAsP-Halbleitermaterial aufweist.

5. Photoleiter gemäß einem der vorhergehenden Ansprüche, wobei die photoleitende Halbleiterschicht (64) mit Beryllium dotiert ist.

6. Photoleiter gemäß einem der vorhergehenden Ansprüche, wobei die Halbleitergrenzschichten (62) ein InAlAs-Halbleitermaterial aufweisen.

7. Photoleiter gemäß einem der vorhergehenden Ansprüche, wobei ein Schichtwiderstand der photoleitenden Halbleiterschicht (64) auf über 130 kΩ/sq hinaus erhöht ist.

8. Photoleiter gemäß einem der vorhergehenden Ansprüche, wobei ein Schichtwiderstand der photoleitenden Halbleiterschicht (64) durch die Halbleitergrenzschichten (62) um ein bis zwei Größenordnungen gegenüber einer massivem Schicht eines Materials der photoleitenden Halbleiterschicht (64) gesteigert ist.

9. Photoleiter Anspruch 8, wobei ein Material der photoleitenden Halbleiterschicht (64) InGaAs ist.

10. Antenne zur Abstrahlung und zum Empfang von Terahertz-Strahlung mit einem Photoleiter gemäß einem der vorhergehenden Ansprüche, wobei die Elektroden (36a,b) des Photoleiters mit Leiterbahnen der Antenne verbunden sind.

11. Verfahren zum Herstellen eines Photoleiters, mit folgenden Schritten:
Aufbringen eines Schichtstapels mit einer für einen vorbestimmten Wellenlängenbereich photoleitenden Halbleiterschicht (64) zwischen zwei Halbleitergrenzschichten (62) mit einem größeren Bandabstand als die photoleitende Halbleiterschicht (64) auf einem Substrat (60), wobei die Halbleitergrenzschichten (62) tiefe Störstellen zum Einfangen und zur Rekombinination von freien Ladungsträgern aus der photoleitenden Halbleiterschicht (64) aufweisen und wobei die photoleitende Halbleiterschicht (64) eine Dicke in einem Bereich kleiner 30 nm aufweist;
und
Elektrisches Kontaktieren der photoleitenden Halbleiterschicht (64) zwischen zwei Elektroden (62a,b) für einen lateralen Stromfluss zwischen den Elektroden durch die photoleitende Halbleiterschicht (64),
**dadurch gekennzeichnet, dass**
die Halbleitergrenzschichten (62) eine Konzentration der tiefen Störstellen aufweisen, die größer oder gleich einer Konzentration von freien Ladungsträgern in der photoleitenden Halbleiterschicht (64) ohne eine Wirkung der Halbleitergrenzschichten (62) ist.

12. Verfahren gemäß Anspruch 11, wobei die photoleitende Schicht (64) und die Halbleitergrenzschichten (62) jeweils durch Molekularstrahlepitaxie gewachsen werden.

13. Verfahren gemäß Anspruch 12, wobei
die photoleitende Halbleiterschicht (64) InGaAs ist und bei einer Temperatur (T₂) größer als 200° C gewachsen wird, und
die Halbleitergrenzschichten (62) InAlAs sind und jeweils bei einer Temperatur (T₁) kleiner als 200° C gewachsen werden.

14. Verfahren gemäß Anspruch 12, wobei
die photoleitende Halbleiterschicht (64) InGaAs ist und die Halbleitergrenzschichten (62) InAlAs sind und die photoleitende Halbleiterschicht (64),
die Halbleitergrenzschichten (62) jeweils bei gleichen Temperaturen (T₁, T₂) gewachsen werden, und
die gleichen Temperaturen (T₁, T₂) in einem Bereich von 350° C bis 500° C liegen, oder die gleichen Temperaturen (T₁, T₂) in einem Bereich kleiner 200° C liegen.

## Claims

1. A photoconductor comprising:
a layer stack (72) comprising a semiconductor layer (64) photoconductive for a predetermined wavelength range between two semiconductor boundary layers (62) with a larger band gap than the photoconductive semiconductor layer (64) on a substrate (60), wherein the semiconductor boundary layers (62) comprise deep impurities for trapping and recombining free charge carriers from the photoconductive semiconductor layer (64) and wherein the photoconductive semiconductor layer (64) has a thickness in a range of less than 30 nm; and
two electrodes (36a,b) connected to the photoconductive semiconductor layer (64) for lateral current flow between the electrodes (36a,b) through the photoconductive semiconductor layer (64).
**characterized in that** the semiconductor boundary layers (62) have a concentration of the deep impurities, which is higher than or equal to a concentration of free charge carriers in the photoconductive semiconductor layer (64) without an effect of the semiconductor boundary layers (62).

2. The photoconductor according to claim 1, wherein the layer stack (72) is implemented as mesa structure with lateral contacting of the photoconductive semiconductor layer (64) by the electrodes (36a,b).

3. The photoconductor according to claim 1 or 2, wherein the substrate is an InP or GaAs semiconductor substrate.

4. The photoconductor according to one of the previous claims, wherein the photoconductive semiconductor layer (64) comprises an InGaAs or InGaAsP semiconductor material.

5. The photoconductor according to one of the previous claims, wherein the photoconductive semiconductor layer (64) is doped with beryllium.

6. The photoconductor according to one of the previous claims, wherein the semiconductor boundary layers (62) comprise an InAlAs semiconductor material.

7. The photoconductor according to any one of the previous claims, wherein a layer resistance of the photoconductive semiconductor layer (64) is increased above 130 kΩ/sq.

8. Photoconductor according to any one of the previous claims, wherein a layer resistance of the photoconductive semiconductor layer (64) is increased through the semiconductor boundary layer (62) by one or two magnitudes compared to a massive layer of a material of the photoconductive semiconductor layer (64).

9. Photoconductor according to claim 8, wherein a material of the photoconductive semiconductor layer (64) is InGaAs.

10. An antenna for emitting and receiving terahertz radiation comprising a photoconductor according to one of the previous claims, wherein the electrodes (36a,b) of the photoconductor are connected to conductive traces of the antenna.

11. A method for producing a photoconductor, comprising:
depositing a layer stack comprising a semiconductor layer (64) photoconductive for a predetermined wavelength range between two semiconductor boundary layers (62) with a larger band gap than the photoconductive semiconductor layer (64) on a substrate (60), wherein the semiconductor boundary layers (62) comprise deep impurities for trapping and recombining free charge carriers from the photoconductive semiconductor layer (64) and wherein the photoconductive semiconductor layer (64) has a thickness in a range of less than 30 nm; and
electrically contacting the photoconductive semiconductor layer (64) between two electrodes (62a,b) for lateral current flow between the electrodes through the photoconductive semiconductor layer (64),
**characterized in that** the semiconductor boundary layers (62) have a concentration of the deep impurities, which is higher than or equal to a concentration of free charge carriers in the photoconductive semiconductor layer (64) without an effect of the semiconductor boundary layers (62).

12. The method according to claim 11, wherein the photoconductive layer (64) and the semiconductor boundary layers (62) are each grown by molecular-beam epitaxy.

13. The method according to claim 12, wherein the photoconductive semiconductor layer (64) is InGaAs and is grown at a temperature (T₂) of more than 200°C, and
wherein the semiconductor boundary layers (62) are InAlAs and are each grown at a temperature (T₁) of less than 200°C.

14. Method according to claim 12, wherein
the photoconductive semiconductor layer (64) is InGaAs and the semiconductor boundary layers (62) are InAlAs and the photoconductive semiconductor layer (64),
the semiconductor boundary layer (62) are each grown at the same temperatures (T1, T2), and
the same temperatures (T₁, T₂) are in a range of 350° C to 500° C, or the same temperatures (T₁, T₂) are in as range lower than 200° C.

## Revendications

1. Photoconducteur aux caractéristiques suivantes:
un empilement de couches (72) avec une couche semi-conductrice (64) photoconductrice pour une plage de longueurs d'onde prédéterminée entre deux couches limites semi-conductrices (62) avec une bande interdite plus grande que la couche semi-conductrice photoconductrice (64) sur un substrat (60), où les couches limites semi-conductrices (62) présentent des défauts profonds pour la capture et la recombinaison de porteurs de charge libres de la couche semi-conductrice photoconductrice (64), et où la couche semi-conductrice photoconductrice (64) présente une épaisseur dans une plage inférieure à 30 nm; et
deux électrodes (36a, b) qui sont connectées à la couche semi-conductrice photoconductrice (64) pour une circulation de courant latérale entre les électrodes (36a, b) à travers la couche semi-conductrice photoconductrice (64),
**caractérisé par le fait que**
les couches limites semi-conductrices (62) présentent une concentration de défauts profondes qui est supérieure ou égale à une concentration de porteurs de charge libres dans la couche semi-conductrice photoconductrice (64) sans action des couches limites semi-conductrices (62).

2. Photoconducteur selon la revendication 1, dans lequel l'empilement de couches (72) est réalisé sous forme de structure mesa avec amenée en contact latéral de la couche semi-conductrice photoconductrice (64) par les électrodes (36a, b).

3. Photoconducteur selon la revendication 1 ou 2, dans lequel le substrat est un substrat semi-conducteur en InP ou en GaAs.

4. Photoconducteur selon l'une des revendications précédentes, dans lequel la couche semi-conductrice photoconductrice (64) présente un matériau semi-conducteur InGaAs ou InGaAsP.

5. Photoconducteur selon l'une des revendications précédentes, dans lequel la couche semi-conductrice photoconductrice (64) est dopée de béryllium.

6. Photoconducteur selon l'une des revendications précédentes, dans lequel les couches limites semi-conductrices (62) présentent un matériau semi-conducteur InAlAs.

7. Photoconducteur selon l'une des revendications précédentes, dans lequel une résistance de couche de la couche semi-conductrice photoconductrice (64) est augmentée à plus de 130 kΩ/sq.

8. Photoconducteur selon l'une des revendications précédentes, dans lequel une résistance de couche de la couche semi-conductrice photoconductrice (64) est augmentée par les couches limites semi-conductrices (62) d'un à deux ordres de grandeur par rapport à une couche massive d'un matériau de la couche semi-conductrice photoconductrice (64).

9. Photoconducteur selon la revendication 8, dans lequel un matériau de la couche semi-conductrice photoconductrice (64) est InGaAs.

10. Antenne destinée à émettre et recevoir un rayonnement térahertz avec un photoconducteur selon l'une des revendications précédentes, dans laquelle les électrodes (36a, b) du photoconducteur sont connectées à des pistes conductrices de l'antenne.

11. Procédé de fabrication d'un photoconducteur, aux étapes suivantes consistant à:
appliquer un empilement de couches avec une couche semi-conductrice (64) photoconductrice pour une plage de longueurs d'onde prédéterminée entre deux couches limites semi-conductrices (62) avec une bande interdite plus grande que la couche semi-conductrice photoconductrice (64) sur un substrat (60), où les couches limites semi-conductrices (62) présentent des défauts profonds pour la capture et la recombinaison de porteurs de charge libres de la couche semi-conductrice photoconductrice (64), et où la couche semi-conductrice photoconductrice (64) présente une épaisseur dans une plage inférieure à 30 nm; et
amener en contact électrique la couche semi-conductrice photoconductrice (64) entre deux électrodes (62a, b) pour une circulation de courant latérale entre les électrodes à travers la couche semi-conductrice photoconductrice (64),
**caractérisé par le fait que**
les couches limites semi-conductrices (62) présentent une concentration de défauts profondes qui est supérieure ou égale à une concentration de porteurs de charge libres dans la couche semi-conductrice photoconductrice (64) sans action des couches limites semi-conductrices (62).

12. Procédé selon la revendication 11, dans lequel la couche photoconductrice (64) et les couches limites semi-conductrices (62) sont cultivées, chacune, par épitaxie par faisceau moléculaire.

13. Procédé selon la revendication 12, dans lequel
la couche semi-conductrice photoconductrice (64) est en InGaAs et est cultivée à une température (T₂) supérieure à 200°C, et
les couches limites semi-conductrices (62) sont en InAlAs et cultivées, chacune, à une température (T₁) inférieure à 200°C.

14. Procédé selon la revendication 12, dans lequel
la couche semi-conductrice photoconductrice (64) est en InGaAs et les couches limites semi-conductrices (62) sont en InAlAs et la couche semi-conductrice photoconductrice (64),
les couches limites semi-conductrices (62) sont cultivées, chacune, aux mêmes températures (T₁, T₂), et
les mêmes températures (T₁, T₂) se situent dans une plage de 350°C à 500°C, ou les mêmes températures (T₁, T₂) se situent dans une plage inférieure à 200°C.
